# EUROPEAN PATENT SPECIFICATION

(11) **EP 1 117 177 B1**
(45) Date of publication and mention of the grant of the patent: **21.04.2004**
(21) Application number: 00310744.8
(22) Date of filing: 04.12.2000
(51) Int. Cl.: H03B 5/12, H03B 5/18

(54) **Voltage controlled oscillator**
Spannungsgesteuerter Oszillator
Oscillateur commandé en tension

(30) Priority: 07.01.2000 JP 2000005991
(43) Date of publication of application: 18.07.2001
(73) Proprietor: ALPS ELECTRIC CO., LTD., Ota-ku Tokyo 145 (JP)
(72) Inventor: Tanemura, Takeshi, c/o Alps Electric Co., Ltd., Tokyo 145 (JP)
(74) Representative: Kensett, John Hinton

(56) References cited:
- EP-A- 0 911 960
- PATENT ABSTRACTS OF JAPAN vol. 1997, no. 03, 31 March 1997 (1997-03-31) & JP 08 316731 A (TDK CORP), 29 November 1996 (1996-11-29)

## Description

### BACKGROUND OF THE INVENTION

### 1. Field of the Invention

The present invention relates to a voltage controlled oscillator configured to oscillate in two frequency bands.

### 2. Description of the Prior Art

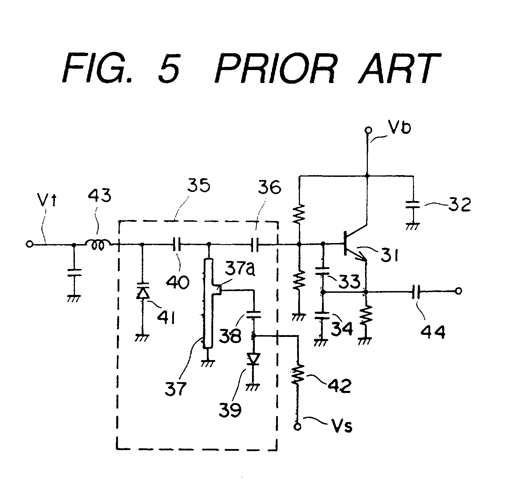

A conventional voltage controlled oscillator is described according to FIG. 5. Required bias voltages are respectively applied to the base and the emitter of an oscillation transistor 31, and the collector to which a supply voltage (Vb) is applied is RF-grounded by a DC cut capacitor 32. Between the base and the emitter and between the emitter and the ground are connected feedback capacitors 33 and 34, respectively.

A resonance circui t 35 is provided between the base and the ground.

The resonance circuit 35 has a Clapp capacitor 36, an inductance element 37, a DC cut capacitor 38, a switch diode 39, a DC cut capacitor 40, a varactor diode 41, and the like. The inductance element 37, constructed of a microstrip line, is connected to the base of the oscillation transistor 31 via the Clapp capacitor 36 at one end thereof and is grounded at the other. The cathode of the varactor diode 41 is connected to the inductance element 37 via the DC cut capacitor 40, and the anode is grounded. The inductance element 37 has a midtap 37a provided at a midway point lengthwise thereof, the anode of the switch diode 39 is connected to the midtap 37a via the DC cut capacitor 38, and the cathode is grounded.

A switching voltage (Vs) of high or low level is applied to the anode of the switch diode 39 via a feeding resistor 42, and a tuning voltage (Vt) is applied to the cathode of the varactor diode 41 via a choke inductor 43.

Upon application of a switching voltage of low level, since the switch diode 39 is brought out of conduction and the midtap 37a of the inductance element 37 is not RF-grounded, the entire inductance element 37 contributes to the setting of an oscillation frequency so that the voltage controlled oscillator oscillates in a first frequency band (about 0.9 GHz band).

On the other hand, upon application of a switching voltage of high level, the switch diode 39 is brought into conduction and the midtap 37a is RF-grounded. As a result, the length of the inductance element 37 to contribute to the setting of an oscillation frequency becomes short so that the voltage controlled oscillator oscillates in a second frequency band (about 1.8-GHz band) higher than the first oscillation frequency band.

In either case, an oscillation frequency changes by changing a tuning voltage. An oscillating signal is outputted from the emitter of the oscillation transistor 31 and inputted to a buffer amplifier (not shown) or the like via a coupling capacitor 44.

In the above configuration, to obtain the large frequency ratio between the first frequency band and the second frequency band, the midtap 37 in the inductance 37 must be brought close to one end of the inductance 37. However, the closer the midtap 37a is brought to one end, the larger the level (amplitude) of an oscillating signal in the midtap 37a becomes, so that an oscillating signal of a large amplitude of 0.7 volts or more is applied to the anode of the switch diode 39. Even when the switch diode 39 is not conducting (when the voltage controlled oscillator is oscillating in the first frequency band), the switch diode 39 causes rectification by the oscillating signal. This causes the problem that stable oscillation frequencies cannot be obtained in the first frequency band. In other words, there is the problem that a frequency ratio between the first frequency band and the second frequency band cannot be increased to obtain stable oscillation in the two frequency bands.

Alternative resonance circuits to that which is described above are disclosed in EP-A-0 911 960, and in JP 08 316 731 A.

### SUMMARY OF THE INVENTION

The present invention intends to solve the above problem and provide stable oscillation even if a frequency ratio between the first frequency band and the second frequency band is increased.

According to any aspect of the present invention there is provided a voltage controlled oscillator comprising: an oscillation transistor, and a resonance circuit RF-connected between the collector and base of the oscillation transistor, wherein the resonance circuit includes a first inductance element grounded at one end thereof, a varactor diode connected in parallel with the first inductance element, a second inductance element connected in parallel with the first inductance element, and a switch transistor switchable between an 'on' or 'off' state, characterised in that the second inductance element is connected in parallel with the first inductance element via the path of the collector and the emitter of the switch transistor, and in that the second inductance element is constructed of a first microstrip line and a second microstrip line, wherein both the length of the first microstrip line and the length of the second microstrip line are one-eighth or less the wavelength of an oscillation frequency, and the switch transistor is provided between the first microstrip line and the second microstrip line, and wherein the first microstrip line is connected to the first inductance element as a capacitance component when the switch transistor is in an 'off' state.

### BRIEF DESCRIPTION OF THE DRAWINGS

A preferred embodiment of the present invention will be described in detail based on the followings, wherein:
FIG. 1 is a schematic diagram showing a first voltage controlled oscillator;
FIG. 2 is a schematic diagram showing a second voltage controlled oscillator;
FIG. 3 is a schematic diagram showing the configuration of a variant of a voltage controlled oscillator of figure 2;
FIG. 4 is a schematic diagram showing the configuration of the voltage controlled oscillator of the present invention; and
FIG. 5 is a schematic diagram showing the configuration of a conventional voltage controlled oscillator.

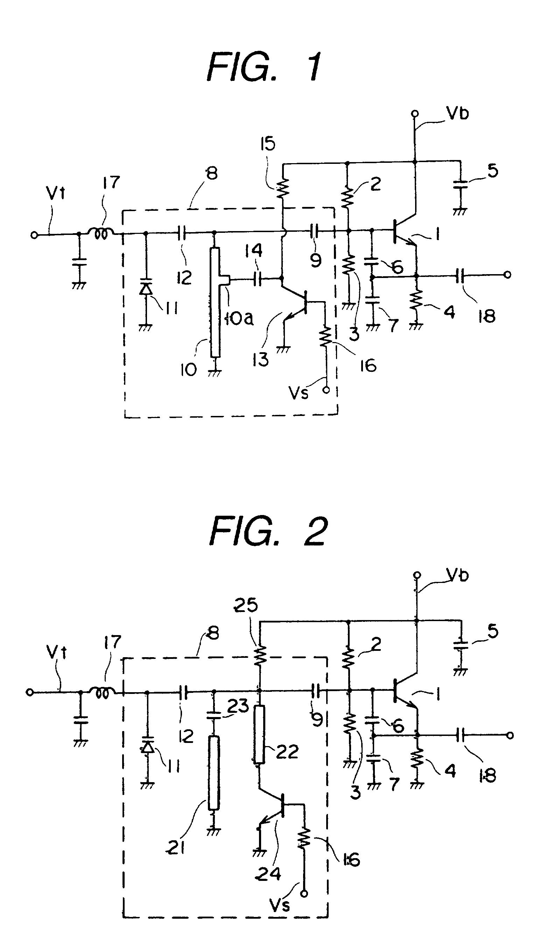

The oscillators shown in figures 1, 2, 3 and 5 do not form part of the present invention.

### DESCRIPTION OF THE PREFERRED EMBODIMENTS

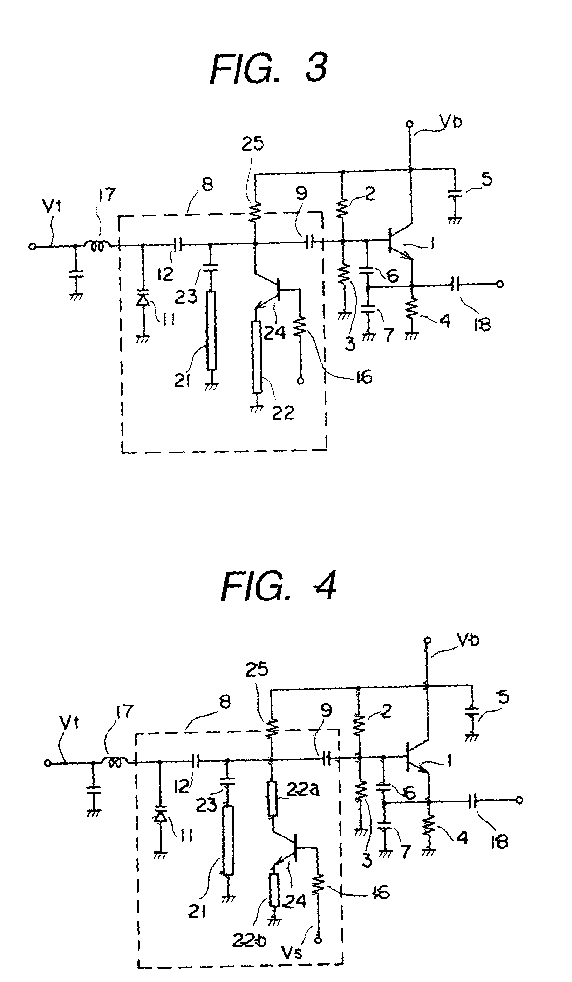

The oscillator of the present invention will be described with reference to FIG 4. FIG. 1 shows a voltage controlled oscillator. Required bias voltages are respectively applied to the base and the emitter of an oscillation transistor 1 by bias resistors 2, 3, and 4. The collector to which a supply voltage (Vb) is applied is RF-grounded by a DC cut capacitor 5. Between the base and the emitter and between the emitter and the ground are connected feedback capacitors 6 and 7, respectively. A resonance circuit 8 is provided between the base and the ground.

The resonance circuit 8 comprises a Clapp capacitor 9, an inductance element 10 constructed of a microstrip line, a varactor diode 11, and the like.

One end of the inductance element 10 is connected to the base of the oscillation transistor 1 via the Clapp capacitor 9, and the other is grounded. The cathode of the varactor diode 11 is connected to one end of the inductance element 10 via a DC cut capacitor 12 and the anode is grounded. The inductance element 10 is provided with a midtap 10a at a midway point lengthwise thereof, the collector of the switch transistor 13 is connected to the midtap 10a via a DC cut capacitor 14, and the emitter is grounded. A supply voltage is applied to the collector via a feeding resistor 15.

As a result, the other end of the inductance element 10, the anode of the varactor diode 11, and the emitter of the switch transistor 13 are RF-connected to the collector of the oscillation transistor 1, whereby the resonance circuit 8 is provided at high frequencies between the base and the collector of the oscillation transistor 1.

To the base of the switch transistor 13 is applied a switching voltage (Vs) of high or low level via the feeding resistor 16 from a switch circuit not shown. A tuning voltage (Vt) is applied to the cathode of the varactor diode 11 via the choke inductance 17.

When a switching voltage of low level is applied to the base of the switch transistor 13, it is brought out of conduction (turned off) between the collector and the emitter, and the midtap 10a of the inductance element 10 is not RF-grounded. Consequently, the entire inductance element 10 contributes to the setting of an oscillation frequency so that the voltage controlled oscillator oscillates in a first frequency band (about 0.9 GHz band).

In this case, since a collector voltage of the switch transistor 13 is almost equal to the supply voltage, the switch transistor 13 is not easily turned on by an oscillating signal developing in the midtap 10a.

Furthermore, since the switch transistor 13 is brought into conduction with a small amount of base current, the switch circuit spends a slight current.

On the other hand, when a switching voltage of high level is applied to the base of the switch transistor 13, it is brought into conduction (turned on) and the midtap 10a is RF-grounded. As a result, the length of the inductance element 10 to contribute to a resonance circuit 35 becomes short so that the voltage controlled oscillator oscillates in a second frequency band (about 1.8 GHz band) higher than the first oscillation frequency band.

In either case, an oscillation frequency changes by changing a tuning voltage. An oscillating signal is outputted from the emitter of the oscillation transistor 31 and inputted to a buffer amplifier (not shown) or the like via a coupling capacitor 18.

Although bringing the position of the midtap 10a of the indurctance element 10 close to one end thereof increases the level (amplitude) of the oscillating signal, in the above configuration, the switch transistor 13 is not brought into conduction because a supply voltage is applied to the collector when it is out of conduction (when the voltage controlled oscillator is oscillating in the first frequency band). Accordingly, the second frequency band can be increased, so that a ratio between the first frequency band and the second frequency band can be increased.

FIG. 2 shows a second voltage controlled oscillator; the resonance circuit 8 comprises the Clapp capacitor 9, a first inductance element 21, a second inductance element 22, the varactor diode 11, and the like.

The first inductance element 21 and the second inductance element 22 are respectively constructed of a microstrip line whose line length is one-fourth or less the wavelength of an oscillation frequency.

One end of the first inductance element 21 is connected to the Clapp capacitor 9 via a DC cut capacitor 23 and the other end is grounded. The cathode of the varactor diode 11 is connected to the Clapp capacitor 9 via the DC cut capacitor 12 and the anode is grounded. One end of the second inductance element 22 is connected to the Clapp capacitor 9 and the other end is connected to the collector of a switch transistor 24. To the collector of the switch transistor 24 is applied a supply voltage via a feeding resistor 25 and the second inductance element 22, which are connected in series.

As a result, the second inductance element 22 is connected in parallel with the first inductance element 21 via the path of the collector and the emitter of the switch transistor 24.

The other end of the first element 21, the anode of the varactor diode 11, and the emitter of the switch transistor 24 are RF-connected to the collector of the oscillation transistor 1, whereby the resonance circuit 8 is provided at high frequencies between the base and the collector of the oscillation transistor 1.

To the base of the switch transistor 24 is applied a switching voltage (Vs) of high or low level via the feeding resistor 16, and to the cathode of the varactor diode 11 is applied a tuning voltage (Vt) via the choke inductance 17.

When a switching voltage of low level is applied to the base of the switch transistor 24, it is brought out of conduction (turned off) between the collector and the emitter, the other end of the second inductance element 22 is freed so that the first inductance element 21 and the second inductance element 22 are not connected in parallel, and primarily the first microstrip line 21 contributes to the setting of an oscillation frequency and the voltage controlled oscillator oscillates in the first frequency band (about 0.9 GHz band). In this case, although an oscillating signal of high level is applied to the collector of the oscillation transistor 24 because the other end of the second inductance element 22 is in a freed state, the switch transistor 24 is not turned on because the switching voltage of low level applied to the base thereof causes the supply voltage to be applied to the collector thereof.

On the other hand, the switch transistor 24, when a switching voltage of high level is applied to the base thereof, is brought into conduction, and the other end of the second inductance element 22 is RF-grounded. As a result, the first inductance element 21 and the second inductance element 22 are connected in parallel with each other and the voltage controlled oscillator oscillates in a second frequency band (about 1.8 GHz band) higher than the first oscillation frequency band.

If the second inductance element 22 is constructed of a microstrip line, when the switch transistor 24 is out of conduction, since the second inductances element 22 is connected in parallel with the first inductance element 21 as a capacity component, the first frequency band decreases and a frequency ratio between the first, frequency band and the second frequency band can be increased.

FIG. 3 is a variant of the voltage controlled oscillator shown in FIG. -2, wherein the second inductance 22 and the switch transistor 24 are reversed in position.

That is, one end of the second inductance 22 is grounded and the other end is connected to the emitter of the switch transistor 24. The collector of the switch transistor 24 is connected to the Clapp capacitor 9. A supply voltage is applied to the collector via the feeding resistor 25. The configuration of other components is the same as that in FIG. 1.

Also in this case, when the switch transistor 24 is out of conduction, the voltage controlled oscillator oscillates in the first frequency band, and when brought into conduction, it oscillates in the second frequency band. However, when out of conduction, since one end of the second inductance element 22 is disconnected from the first inductance element 21, no influence is exerted on the first oscillation frequencies. Accordingly, oscillation frequencies of the first frequency band can be set by only the first inductance 21.

Also, since the other end of the second inductance element 22 is grounded and one end thereof is connected to the Clapp capacitor 9 via the switch transistor 24, when the second microstrip line 22 is constructed of a microstrip line, even if an equivalent resistance (saturated resistance) at conduction of the switch transistor 24 exists, Q when the second inductance element 22 is observed from the collector of the switch transistor 24 becomes high.

FIG. 4 which shows the voltage controlled oscillator of the present invention, is a variant of the voltage controlled oscillator shown in FIG. 2, wherein the second inductance element 22 is split into two microstrip lines, a first microstrip line 22a and a second microstrip line 22b, and the switch transistor 24 is provided between the first microstrip line 22a and the second microstrip line 22b. The length of the first microstrip line 22a and the length of the second microstrip line 22b are equal to each other and are one-eighth or less the wavelength of an oscillation frequency.

That is, one end of the first microstrip line 22a is connected to the Clapp capacitor 9, the other end thereof is connected to the collector of the switch transistor 24, one end of the second microstrip line 22b is connected to the emitter of the switch transistor 24, and the other end thereof is grounded.

In this configuration, when the switch transistor 24 is out of conduction, since the other end of the first microstrip line 22a is freed, the voltage controlled oscillator oscillates in the first frequency band; when the switch transistor 24 is brought into conduction, the microstrip line 22a and the second microstrip line 22b are connected in series with each other and are connected in parallel with the first inductance 21, so that the voltage controlled oscillator oscillates in the second frequency band. When the voltage controlled oscillator oscillates in the first frequency band, since only the first microstrip line 22a with the other end freed is connected with the first inductance element 21, it is connected in parallel with the first inductance 21 as a capacity component, so that the first frequency band decreases and a frequency ratio between the first frequency band and the second frequency band can be increased.

Where the switch diode 24 is brought into conduction, an equivalent resistance (saturated resistance) by the switch transistor 24 exists between the first microstrip line 22a and the second microstrip line 22b, Q of the second inductance element 22 when the equivalent resistance is included becomes a middle value between Q in FIG. 2 and Q in this drawing.

Although an NPN transistor is used as the switch transistor 24 as shown in the drawing, a PNP transistor may be used. Where a PNP transistor is used, the collectors in FIGS. 1 to 4 may be replaced by emitters, and the emitters by collectors.

Although the collector of the oscillation transistor 1 is RF-grounded, the base may be RF-grounded.

As has been described above, the oscillator of the present invention comprises a resonance circuit connected between the base and collector of an oscillation transistor, the resonance circuit having a midtap, an inductance element with one end thereof grounded, a varactor diode connected in parallel with the inductance element, and a switch transistor switched on or off, wherein either of the collector and the emitter of the switch transistor is connected with the midtap and the other is grounded. Therefore, when the switch transistor is brought out of conduction and the oscillator is oscillating in the first frequency band, since the collector voltage of the switch transistor is almost equal to a supply voltage, the switch transistor is not easily turned on by an oscillating signal developing in the midtap 10a. Accordingly, a frequency ratio between the first frequency band and the second frequency band can be increased.

Furthermore, since the switch transistor is brought into conduction with a small amount of base current, the switch circuit spends a slight current.

The oscillator of the present invention has the resonance circuit that comprises a first inductance element with one end thereof grounded, the varactor diode connected in parallel with the first inductance element, a second inductance element connected in parallel with the first inductance element, and the switch transistor switched on or off, wherein the second inductance element is connected in parallel with the first inductance element via the collector and the emitter of the switch transistor. Therefore, the switch transistor, when on, is not turned on by an oscillating signal.

In the oscillator of the present invention, the second inductance element is constructed of a first microstrip line and a second microstrip line, wherein both the length of the first microstrip line and the length of the second microstrip line are one-eighth or less an oscillation frequency, and the switch transistor is provided between the first microstrip line and the second microstrip line. Therefore, when the switch transistor is out of conduction, since the other end of the first microstrip line is freed, only the first microstrip line is connected in a freed state to the first inductance element and the second inductance element is connected in parallel with the first inductance element as a capacity component, so that the first frequency band decreases and a frequency ratio between the first frequency band and the second frequency band can be increased.

## Claims

1. A voltage controlled oscillator comprising: an oscillation transistor (1), and a resonance circuit (8) RF-connected between the collector and base of the oscillation transistor, wherein the resonance circuit includes a first inductance element (21) grounded at one end thereof, a varactor diode (11) connected in parallel with the first inductance element, a second inductance element (22) connected in parallel with the first inductance element, and a switch transistor (24) switchable between an 'on' or 'off' state, **characterised in that** the second inductance element is connected in parallel with the first inductance element via the path of the collector and the emitter of the switch transistor, and **in that** the second inductance element is constructed of a first microstrip line (22a) and a second microstrip line (22b), wherein both the length of the first microstrip line and the length of the second microstrip line are one-eighth or less the wavelength of an oscillation frequency, and the switch transistor is provided between the first microstrip line and the second microstrip line, and wherein the first microstrip line is connected to the first inductance element as a capacitance component when the switch transistor is in an 'off' state.

## Patentansprüche

1. Spannungsgesteuerter Oszillator, umfassend: einen Oszillationstransistor (1) und eine Resonanzschaltung (8), welche HF-mäßig zwischen den Kollektor und die Basis des Oszillationstransistors geschaltet ist, wobei die Resonanzschaltung ein erstes Induktanzelement (21), welches an einem Ende geerdet ist, eine Varaktordiode (11), welche parallel zu dem ersten Induktanzelement geschaltet ist, ein zweites Induktanzelement (22), welches parallel zu dem ersten Induktanzelement geschaltet ist, und einen Schalttransistor (24), welcher zwischen einem "EIN"- oder "AUS"-Zustand schaltbar ist, aufweist, **dadurch gekennzeichnet, dass** das zweite Induktanzelement über den Pfad des Kollektors und des Emitters des Schalttransistors zu dem ersten Induktanzelement parallel geschaltet ist und dass das zweite Induktanzelement aus einer ersten Mikrostreifenleitung (22a) und einer zweiten Mikrostreifenleitung (22b) aufgebaut ist, wobei sowohl die Länge der ersten Mikrostreifenleitung als auch die Länge der zweiten Mikrostreifenleitung ein Achtel oder weniger der Wellenlänge einer Oszillationsfrequenz sind, wobei der Schalttransistor zwischen der ersten Mikrostreifenleitung und der zweiten Mikrostreifenleitung vorgesehen ist und wobei die erste Mikrostreifenleitung mit dem ersten Induktanzelement als eine Kapazitätskomponente verbunden ist, wenn der Schalttransistor in einem "aus"-Zustand ist.

## Revendications

1. Oscillateur commandé en tension comprenant :
un transistor d'oscillation (1), ainsi qu'un circuit résonant (8) branché en radiofréquence (RF) entre le collecteur et la base du transistor d'oscillation, dans lequel le circuit résonant comprend un premier élément d'inductance (21) mis à la masse à l'une de ses extrémités, une diode varactor (11) branchée en parallèle avec le premier élément d'inductance, un deuxième élément d'inductance (22) branché en parallèle avec le premier élément d'inductance, et un transistor de commutation (24) commutable entre un état "ouvert" et un état "fermé", **caractérisé en ce que** le deuxième élément d'inductance est branché en parallèle avec le premier élément d'inductance par l'intermédiaire de la ligne du collecteur et de l'émetteur du transistor de commutation, et **en ce que** le deuxième élément d'inductance est constitué d'une première ligne microbande (22a) et d'une deuxième ligne microbande (22b), où la longueur de la première ligne microbande et la longueur de la deuxième ligne microbande ont toutes deux une valeur égale ou inférieure à un huitième de la longueur d'onde de la fréquence d'oscillation, dans lequel le transistor de commutation est prévu entre la première ligne microbande et la deuxième ligne microbande, et dans lequel la première ligne microbande est reliée au premier élément d'inductance en tant que composant capacitif quand le transistor de commutation est à l'état "fermé".
